# EUROPEAN PATENT SPECIFICATION

(11) **EP 3 312 885 B1**
(45) Date of publication and mention of the grant of the patent: **07.05.2025**
(21) Application number: 16194382.4
(22) Date of filing: 18.10.2016
(51) Int. Cl.: H01L 29/775, H01L 29/06, H01L 29/66, H01L 21/02, B82Y 10/00, B82Y 40/00, H01L 29/16

(54) **METHOD FOR FORMING NANOWIRES FROM STRAINED LAYERS ON SURFACES OF A FIN**
VERFAHREN ZUR HERSTELLUNG VON NANODRÄHTEN AUS GESPANNTEN SCHICHTEN AUF OBERFLÄCHEN EINES FINS
PROCÉDÉS DESTINÉS À FORMER DES NANOFILS D'UN MATÉRIAU CONSTRAINT SUR DES SURFACES D'UN AILETTE

(43) Date of publication of application: 25.04.2018
(73) Proprietor: IMEC VZW, 3001 Leuven (BE)
(72) Inventor: MITARD, Jerome, 3001 Leuven (BE)
(74) Representative: Winger

(56) References cited:
- EP-A1- 2 924 738
- US-A1- 2009 291 311
- US-A1- 2010 164 102
- US-A1- 2014 273 423
- US-A1- 2015 123 146
- US-B1- 9 379 182

## Description

### Technical field of the invention

The present invention relates to a method for forming a semiconductor device comprising nanowires.

### Background of the invention

In the endless quest to uphold Moore's law, continuous efforts are being made to further develop the architectures and fabrication methods of transistors and other semiconductor devices. A cornerstone goal in this pursuit is to further scale down the device footprint of individual transistors. In order to achieve this goal, not only are endeavours made to further decrease the dimensions of the different transistor features, such as the channel; the industry is also increasingly moving away from classical planar device architectures towards multigate devices, such as fin field effect transistors (FinFETs). In accordance with this evolution, it is believed that further developments in the field will eventually lead to the adoption of so called '*gate-all-around*' architectures.

A limitation of the current device architectures is that the creation of a complementary metal-oxide-semiconductor (CMOS) device requires distinct p- and n-type FETs, which need to be connected at the middle- or back-end-of-line level. As such, the ability to create closely packed p- and n-type FETs which can be connected at the active device level would constitute a tremendous leap forward.

US 2014/0273423 A1 discloses one method including forming a layer of silicon/germanium having a germanium concentration of at least 30% on a semiconducting substrate, forming a plurality of spaced-apart trenches that extend through the layer of silicon/germanium and at least partially into the semiconducting substrate, wherein the trenches define a fin structure for the device comprised of a portion of the substrate and a portion of the layer of silicon/germanium, the portion of the layer of silicon/germanium having a first cross sectional configuration, forming a layer of insulating material in the trenches and above the fin structure, performing an anneal process on the device so as to cause the first cross-sectional configuration of the layer of silicon/germanium to change to a second cross-sectional configuration that is different from the first cross-sectional configuration; and forming a final gate structure around at least a portion of the layer of silicon/germanium having the second cross-sectional configuration. The width of the trenches may range from about 15-80 nm and the method disclosed does not describe how nanowires within less than 15 nm of one another could be achieved.

US9379182B1 discloses a method for forming germanium nanowires comprises forming a semiconductor fin structure including alternating fin and shallow trench structures, etching a top portion of the fin to form a fin recess and depositing a germanium-based semiconductor into the fin recess as a germanium-based plug. The method comprises etching the shallow trench structure to expose the germanium-based semiconductor side faces. The exposed germanium-based semiconductor undergoes annealing to form high carrier mobility nanowire structures. The nanowire structures can also be formed of different diameters by selective oxidation of some of the deposited germanium-based plugs. Alternately, forming fin structures of different widths results in deposited germanium plugs of different widths to be deposited to form different thicknesses of nanowires. However, the minimal distance between the nanowires is defined by the achievable inter-fin distance.

US2010/164102 describes a method of and an apparatus for providing a wafer, the wafer including Silicon; etching trenches in the wafer to form Silicon fins; filling Silicon Oxide in the trenches; planarizing the Silicon Oxide; recessing the Silicon Oxide to a first thickness to form exposed Silicon pedestals from the Silicon fins; depositing SiGe over the exposed Silicon pedestal; recessing the Silicon Oxide to a second thickness; undercutting the exposed Silicon pedestals to form necked-in Silicon pedestals; oxidizing thermally and annealing the SiGe; and forming Germanium nanowires. Here also, the minimal distance between the nanowires is defined by the achievable inter-fin distance, which is described as being from 14 to 189 nm.

EP2924738 describes a gate-all-around semiconductor device and a method for manufacturing a gate-all-around (GAA) semiconductor device. The method comprises providing on a semiconductor substrate in between STI regions at least one suspended nanostructure anchored by a source and a drain region, the suspended nanostructure comprising a crystalline semiconductor material which is different from the semiconductor substrate. A gate stack is provided around the at least one suspended nanostructure. A very high density of nanostructure is however not achievable by this method.

US2009/291311 describes a method of forming a nanowire at one or more predetermined locations on a substrate comprising the steps of: forming a mask member over said substrate; forming an elongate window in said mask member at each of one or more locations at which it is required to form said nanowire thereby to expose a portion of a surface of said substrate; etching a portion of said substrate exposed by said window at said one or more locations to form one or more grooves in said substrate; forming a layer of a wire medium over a surface of said groove; and annealing said structure thereby to form said nanowire in each of said one or more grooves. A very high density of nanostructure is however not achievable by this method.

US2015/123146 describes a semiconductor structure including a bulk silicon substrate and one or more silicon fins coupled to the bulk silicon substrate. Stress-inducing material(s), such as silicon, are epitaxially grown on the fins into naturally diamond-shaped structures using a controlled selective epitaxial growth. The diamond shaped structures are subjected to annealing at about 750° C to about 850° C to increase an area of surface orientation by reshaping the shaped structures from the annealing. Additional epitaxy is grown on the increased area. Multiple cycles of increasing the area of surface orientation (e.g., by the annealing) and growing additional epitaxy on the increased area are performed to decrease the width of the shaped structures, increasing the space between them to prevent them from merging, while also increasing their volume. The formation of nanowires is not discussed. There is thus still a need within the art for better structures and fabrication methods which can enable or facilitate the use of advanced architectures, such as gate-all-around and/or closely packed p- and n-type FETs.

### Summary of the invention

It is an object of the present invention to provide a good method for forming semiconductor devices comprising nanowires.

It is an advantage of embodiments of the present invention that the nanowires can be obtained in a small number of steps.

It is an advantage of embodiments of the present invention that a nanowire semiconductor device can be obtained for sub-10nm technology node, such as 7 nm technology node or even 5 nm technology node. It is a further advantage that such sub-10 nm technology node semiconductor devices may be obtained by using standard modules.

It is an advantage of embodiments of the present invention that the nanowires can form part of a gate-all-around-type semiconductor device.

It is an advantage of embodiments of the present invention that a plurality of nanowires can be formed on a single wall of an elongated structure or around a single elongated structure.

It is an advantage of embodiments of the present invention that the individual nanowires in this plurality of nanowires can be spatially separated yet within 30 nm of one another.

It is an advantage of embodiments of the present invention that some of the nanowires in this plurality of nanowires can be p-doped while others can be n-doped.

It is an advantage of embodiments of the present invention that semiconductor devices comprising stacked/closely packed p- and n-doped nanowires can be obtained.

It is an advantage of embodiments of the present invention that a dense pitch nanowire semiconductor device can be obtained. The final nanowire pitch depends on the initial width of an elongated structure and will thus be smaller than the elongated structure pitch. A final nanowire pitch below 10 nm or even below 7 nm may be obtained,

The above objective is accomplished by methods and devices directly obtained by such methods according to the claims of the present invention.

In a first aspect, the present invention relates to a method for fabricating a semiconductor device as defined in claim 1.

An intermediate structure in the fabrication of a semiconductor device, not forming part of the invention but considered useful for understanding the invention, is disclosed
comprising a semiconductor substrate having a plurality of parallel elongated structures thereon and a semiconductor nanowire on corresponding surfaces of each of these parallel elongated structures.

A semiconductor device not forming part of the invention but considered useful for understanding the invention, is disclosed comprising a plurality of parallel nanowires wherein each nanowire is located within 30 nm, preferably within 20 nm, more preferably within 10 nm, yet more preferably within 7 nm of another nanowire.

A method for fabricating a semiconductor device not forming part of the invention but considered useful for understanding the invention, is disclosed, comprising:
a. Providing a stack of layers comprising a strained layer of a first semiconductor material between two layers of a second semiconductor material,
b. removing part of the layers of the second semiconductor material at an extremity thereof, thereby reducing a contact area of the strained layer with the layers of the second semiconductor material, thereby freeing at least an extremity of the strained layer, said freed extremity extending from the stack, and
c. annealing the freed extremity.

A semiconductor device not forming part of the invention but considered useful for understanding the invention, is disclosed comprising a stack of layers comprising a layer of a first semiconductor material between layers of a second semiconductor material, wherein at least an extremity of the layer of a first semiconductor material extends from the stack and is rounded.

Particular and preferred aspects of the invention are set out in the accompanying independent and dependent claims. Features from the dependent claims may be combined with features of the independent claims and with features of other dependent claims as appropriate within the scope of the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 shows a schematic representation of different lattice constants as materials are grown strained on other materials in embodiments of the present invention.
Fig. 2 shows electron microscope images of structures obtained in accordance with an embodiment of the first aspect of the present invention.
Fig. 3 shows a schematic representation of an embodiment not falling within the scope of the claims but useful to understand the first aspect of the present invention.
Fig. 4 to 6 and 8 to 9 shows schematic representations of a number of different embodiments of the first aspect of the present invention.
Fig. 7 shows an electron microscope image of a fin used for fabricating a semiconductor device according to an embodiment of the present invention.
Fig. 10 shows a schematic representation of a semiconductor device not forming part of the invention but considered useful for understanding the invention.
Fig. 11 shows an electron microscope image of a a semiconductor device not forming part of the invention but considered useful for understanding the invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, layer or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures (3) or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Reference will be made to transistors. These are devices having a first main electrode such as a source, a second main electrode such as a drain and a control electrode such as a gate for controlling the flow of electrical charges between the first and second main electrodes.

The following terms are provided solely to aid in the understanding of the invention.

As used herein, the length (l), width (w) and thickness (t) of a three-dimensional object, such as an elongated structure, or a nanowire, are the longest, intermediate and shortest of the three dimensions of the object, respectively.

As used herein, the length (1) and width (w) of a two-dimensional object, such as a surface or a wall are the longest and shortest of the two dimensions of the object, respectively.

Whenever it is referred to the term *"nanowire"* in the disclosure, it refers to a structure having a width and a thickness below 100 nm, having the ratio of the length to the width greater than two, and having a width/thickness ratio from 1 to 3. More typically, the width and the thickness are below 30 nm, yet more typically 25 nm or below. More typically, nanowires have a length/width ratio greater than five. More typically, the width/thickness ratio is from 1 to 2 and more typically from 1 to 1.5. Often also the terms *"nanoribbon", "semiconductor wire"* or *"nanosheet"* are used in the literature. A nanoribbon refers to a nanowire having asymmetric thickness to width ratio, whereas a symmetric nanowire refers to a nanowire having equal thickness and width and thus has symmetric thickness to width ratio (i.e. 1 to 1). The nanowire may have a cylindrical shape, having a radius and a length. In the present description, the concepts and techniques described applied to nanowires can equally be applied to nanoribbons and to symmetrical nanowires. A nanowire may further be fabricated in two geometries being lateral and vertical. A lateral nanowire has a lateral orientation towards the substrate or substrate surface. It may also be referred to as horizontal nanowire. A vertical nanowire has its orientation perpendicular or vertical towards that substrate or substrate surface. The nanowire referred to in the present disclosure refers to a lateral (or horizontal) nanowire. The horizontal nanowire referred to in the present disclosure comprise two ends, one at each side of the nanowire.

As used herein, a strained layer is a layer which is deformed under the action of an applied force, called stress. In absence of this force, at equilibrium, the layer will be in its relaxed (i.e. unstrained) state. In the context of the present invention, the strained layer will typically be a strained monocrystalline layer adopting (strained) lattice constants differing from its intrinsic lattice constants (cf. infra). The deformation of the lattice is the result of a stress component applied to the material, leading to a (e.g. compressive or tensile) strain. Such an external stress occurs when the material is for example epitaxially grown on a monocrystalline surface which has at least one of its lattice constants which is different from the corresponding intrinsic lattice constants of the material making up the layer.

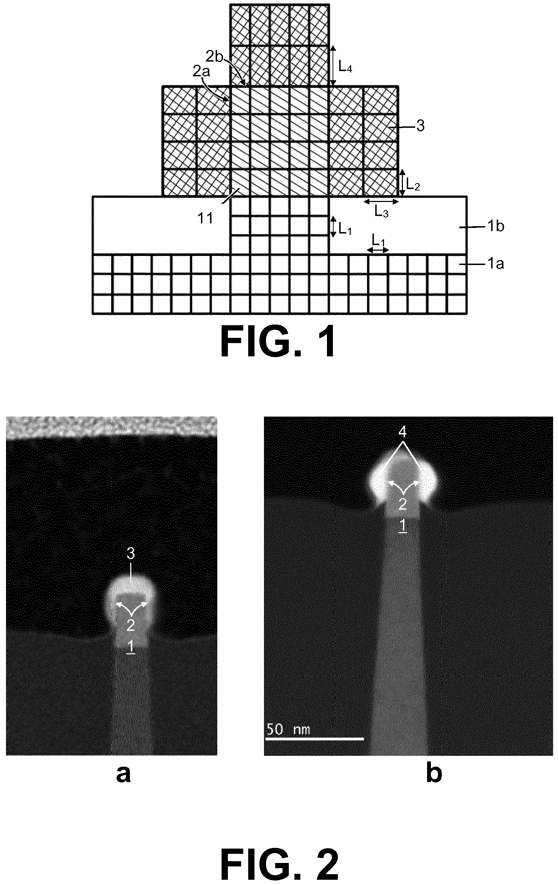

As used herein, a distinction is made between intrinsic lattice constants, i.e. the relaxed lattice constants of the material in its unstrained state, and actual lattice constants of a monocrystalline material or surface, i.e. the lattice constants of the monocrystalline material or surface as it is present in the structure of interest and which may be equal to or different from its intrinsic lattice constants. Furthermore, it should be appreciated that a material may display a different lattice constant (a, b, and c) for each of its three dimensions (X, Y and Z). Preferably, the semiconductor materials used in the present invention (for the elongated structures and/or for the strained semiconductor layer epitaxially grown thereon), have a cubic crystal structure and more preferably a face-centred cubic structure (e.g. as for group IV materials such as Si, Ge or SiGe and most III-V compounds). In these cases, in their relaxed state, all of the lattice constants of a particular semiconductor material are equal and the semiconductor material is said to have a single lattice constant (a). When strained however, the three lattice constants can differ. Unless otherwise indicated, a comparison of a lattice constant between different materials and/or surfaces is always performed between lattice constants in the same direction. In particular, when a further material is epitaxially grown on top of a prior material, the further material will typically adopt actual lattice constants, in the two directions parallel to its contact area with the prior material, equal to the actual lattice constants of the prior material in these two directions. In function of the difference in lattice constant between the actual lattice constants of the prior material and the intrinsic lattice constants of the further material, several situations are possible. If the two relevant intrinsic lattice constants of the further material are both smaller than the corresponding actual lattice constants of the prior material, the further material will be said to display tensile strain. If the two relevant intrinsic lattice constants of the further material are both larger than the corresponding actual lattice constants of the prior material, the further material will be said to display compressive strain. If one relevant intrinsic lattice constant of the further material in a first direction is smaller than the corresponding actual lattice constant of the prior material, and if the other relevant intrinsic lattice constant of the further material in a second direction is larger than the corresponding actual lattice constant of the prior material, the further material will be said to display tensile strain in the first direction and compressive strain in the second direction. This last situation is possible even if both the prior material and the further material have both an intrinsic cubic crystal structure if for instance the prior material was itself already strained. Indeed, if two actual lattice constants of a material are forced to adopt larger or smaller values, the material will seek to at least partially compensate the strain by adopting a respectively smaller or larger third actual lattice constant. An illustration of the concepts described in this paragraph is shown in Fig.1 and is discussed in the examples.

In a first aspect, the present invention relates to a method for fabricating a semiconductor device, comprising the steps of:
a. providing a semiconductor substrate having one or more elongated structures thereon and a strained layer of semiconductor material on at two or more surfaces of each of the one or more elongated structures, and
b. annealing the one or more strained layers, thereby forming two or more semiconductor nanowires on each of the one or more elongated structures from the one or more strained layers present on the two or more surfaces.

It was surprisingly found within the present invention that upon relaxing (i.e. upon reducing and preferably suppressing the strain in) a layer of strained semiconductor material present on a substrate surface, the layer reflows (i.e. the semiconductor material rearranges spatially), while remaining in the solid state (i.e. without melting). This effect can advantageously be used to form a nanowire from the layer of semiconductor material by letting the reflow proceed until a nanowire is formed.

The basic physical mechanism behind reflow of a semiconductor material is a minimization of the substrate surface energy, or in other words the semiconductor layer on the underlying semiconductor surface will change shape so as to minimize its surface area.

Without being bound by theory, the strained semiconductor material has an increased potential energy as compared to the intrinsic semiconductor material, thus relaxing the strained semiconductor material typically is a thermodynamically favourable transition. An increase in the potential energy of the semiconductor material may for example be due to a mismatch between the intrinsic lattice constants of the semiconductor material and the actual (intrinsic or strained) lattice constant of the surface it is on, which forces the semiconductor material of the layer to adopt a strained lattice and in turn increases its potential energy. Upon relaxation, the semiconductor material tends to adopt a rounder shape, while its length (1), parallel to the substrate, tends not to change significantly, thereby forming a nanowire. A rounder shape typically results in a reduced contact area with the substrate and/or an increased volume-to-surface ratio, both of which typically lead to a reduction in potential energy.

In embodiments, step a may comprise step a1 of providing a semiconductor substrate having one or more elongated structures thereon, and step a2 of growing epitaxially a strained layer of semiconductor material on two or more surfaces of the elongated structures.

In embodiments, step a1 may comprise step a11 of providing a semiconductor substrate and step a12 of epitaxially growing one or more elongated structures thereon.

The semiconductor substrate can be of any kind. It can be monolithic or it may be composed of different layers. It is preferable if the top surface of the substrate is monocrystalline as this permits the growth of monocrystalline elongated structures thereon, which is advantageous. Examples of suitable semiconductor substrates are Si, Ge and SiGe wafers as well as such wafers having semiconductor layers epitaxially grown thereon.

The elongated structure is a structure which is longer than it is wide. It comprises at least a surface.

In embodiments, the elongated structures may have a bottom surface in contact with the substrate, a top surface opposite to the bottom surface, two sidewalls opposite each other, a front surface and a back surface opposite the front surface.

In preferred embodiments, the elongated structure may be a fin, i.e. an elongated structure which thickness is parallel to the substrate and which width extends perpendicularly upwards from the substrate. A fin is advantageous since it comprises sidewalls separated by the smallest dimension of the fin (its thickness) thereby permitting a small distance between strained layers present thereon, thereby permitting a small distance between nanowires formed from these layers.

The elongated structure may comprise three exposed sides that are not coplanar, i.e. two side walls and a top wall. In embodiments, the side walls may be parallel or may mutually be at an angle of less than 15°. In embodiments, the elongated structure may have a length of 10 to 60 nm, preferably 15 to 50 nm, yet more preferably 15 to 40 nm. In embodiments, the elongated structure may have a width of 10 to 50 nm, preferably 10 to 40 nm, yet more preferably 10 to 25 nm. The elongated structure may have a thickness of 5 to 50 nm, preferably 5 to 30 nm, yet more preferably 5 to 15 nm. If the thickness of the elongated structure varies along its width, the structure may have a thickness, averaged along its width, of from 5 to 50 nm, preferably 5 to 30 nm, yet more preferably 5 to 15 nm. A small thickness is advantageous as it permits to have a small distance between the sidewalls of an elongated structure and therefore to a have a small distance between the nanowires formed on these sidewalls. On another hand, having a width of at least 30 nm for the top wall of an elongated structure, which is for instance the case for a fin having straight parallel side walls and a thickness of at least 30 nm, facilitates the formation of a nanowire on the top wall. The elongated structure may have a length/width ratio of 2 or more, preferably 3 or more.

In embodiments, the elongated structure may be a sacrificial elongated structure, i.e. an elongated structure which can be removed selectively with respect to the material forming the strained layer and the nanowire obtained therefrom.

The elongated structure comprises a first material forming the surface and optionally the rest of the structure. The first material (6) is preferably a semiconductor material. In preferred embodiments, the first material is a monocrystalline semiconductor material. In embodiments, the surface of the elongated structure is preferably a monocrystalline surface. This is advangtageous because it permits to grow a monocrystalline strained layer epitaxially thereon.

The first material may be unstrained in the state as it is present on the substrate but it can also be in a strained state as exemplified in Fig.1. The first material may for example be SiₓGe_{y}, x, y <= 1, for instance with y from 0.10 to 0.75 such as Si_{0.75}Ge_{0.25} or Si_{0.5}Ge_{0.5}, strained on top of Si and the semiconductor material of the layer may be Ge. In such a case, the SiGe adopts smaller lattice constants than its intrinsic lattice constants in the directions parallel to its contact area with the Si and a larger lattice constant than its intrinsic lattice constant in the direction perpendicular to its contact area with the Si (see discussion of Fig. 1 and example 1).

In typical embodiments, the surface of the elongated structure has a single lattice constant (i.e. both its lattice constants are equal, which is the case for surface 2b in Fig. 1 for instance or when the elongated structure is made of an unstrained semiconductor material with a cubic lattice).

In embodiments, the elongated structure may have at least a surface having two different lattice constants (which is the case for surface 2a in Fig. 1 for instance).

In any embodiment of the first aspect, the one or more elongated structures may be a plurality of parallel elongated structures. This permits the formation of a device comprising more than two parallel nanowires in a same plane parallel to the substrate top surface. The distance between each of these nanowires can be adapted by setting the thickness of the elongated structures and the distance between the elongated structures. The thickness of an elongated structure determines the distance between two nanowires formed on both sidewalls of that elongated structure. The distance between two adjacent elongated structures determine the distance between two adjacent nanowires supported by adjacent elongated structures. When each elongated structure has a nanowire formed on both of its sidewalls, the average distance between any two adjacent nanowires can be half the average distance between any two adjacent elongated structures. As a consequence, by adapting the distance between the elongated structures to their thickness and to the thickness of the nanowires that will form on each of their sidewalls, a regular plurality of equidistant parallel nanowires having a pitch equal to halve of the pitch of the elongated structures supporting them can be obtained. When each elongated structure has a nanowire formed on both its sidewalls, and on its top wall, the average distance between any two adjacent nanowires can be a third of the average distance between any two adjacent elongated structures. As a consequence, by adapting the distance between the elongated structures to their thickness and to the thickness of the nanowires that will form on each of their exposed walls, a regular plurality of equidistant parallel nanowires having a pitch one third of the pitch of the elongated structure supporting them can be obtained.

In any embodiment of the first aspect, the one or more elongated structures may be a plurality of parallel elongated structures, and every elongated structures may have a strained layer of semiconductor material on corresponding surfaces thereof. This permits, if the arrangement of the parallel elongated structures is regular, to form a regular arrangement of parallel nanowires with an average distance between them at least equal and in some embodiment one half or one third of the average distance between the elongated structures.

In any embodiment of the first aspect, the one or more elongated structures may be a plurality of parallel elongated structures, and every elongated structures may have a strained layer of semiconductor material on both sidewalls thereof.

In embodiments, step a may comprise providing a semiconductor substrate having one or more elongated structures thereon, the elongated structures having two sidewalls opposite each other, and wherein a strained layer of semiconductor material is on each sidewall.

In embodiments, step a may comprise providing a semiconductor substrate having one or more elongated structures thereon, the elongated structures having a top surface, and wherein a strained layer of semiconductor material is on each top surface.

In embodiments of the first aspect, the one or more elongated structures may be a plurality of parallel elongated structures, and every elongated structures may have a strained layer of semiconductor material on both sidewalls thereof and on the top wall thereof.

In embodiments, each elongated structure provided in step a may be formed of a stack of layers comprising two layers made of a first material separated by a layer made of a second material, thereby providing elongated structures having sidewalls which each comprises two surfaces made of the first material separated by a surface made of the second material. This splits each sidewall into at least two surfaces made of the first material. If the second material is less favourable to the formation of a layer of semiconductor material thereon than the first material, the at least two surfaces made of the first material will permit the formation of at least two nanowires stacked vertically, thereby increasing the number of nanowires which are formed per elongated structure.

In embodiments, each elongated structure provided in step a is formed of a stack of layers comprising two layers made of a first material separated by a layer made of a second material, thereby providing elongated structures having sidewalls which each comprises two surfaces made of the first material separated by a surface made of the second material, wherein a strained layer of semiconductor material is on each surface made of the first material.

In embodiments, the actual lattice constants of the monocrystalline surfaces of the first material may differ to a greater extent from the corresponding intrinsic lattice constants of the semiconductor material making up the strained layer than the actual lattice constants of the monocrystalline surfaces of the second material. This makes the second material less favourable to the formation of a layer of semiconductor material thereon than the first material. This way the layer of semiconductor material will preferably deposit on the first material, and if it deposits on both the first and second material, it will tend to migrate toward the first material upon annealing, leading to nanowires only on the surfaces made of the first material.

For instance, the actual lattice constants of the second material could be selected to differ by at least 5% and preferably by at least 6% from the intrinsic lattice constants of the semiconductor material making up the strained layer, while the actual lattice constants of the first material could be selected to differ by at most 5% and preferably by at most 4.5% from the intrinsic lattice constants of the semiconductor material making up the strained layer.

In embodiments, the surface made of the first material may have a first lattice constant and the surface made of the second material has a second lattice constant smaller than the first lattice constant.

In preferred embodiments, the actual lattice constants of the monocrystalline surface of second material may be smaller (e.g. by at least 0.5% or preferably by at least 1%) than the actual lattice constants of the monocrystalline surface of first material, and the actual lattice constant of the monocrystalline surface of first material may be smaller (e.g. by at least 1%) than the intrinsic lattice constant of the semiconductor material making up the layer. This permits the layer of semiconductor material to be compressively strained, which is favourable to the formation of a nanowire.

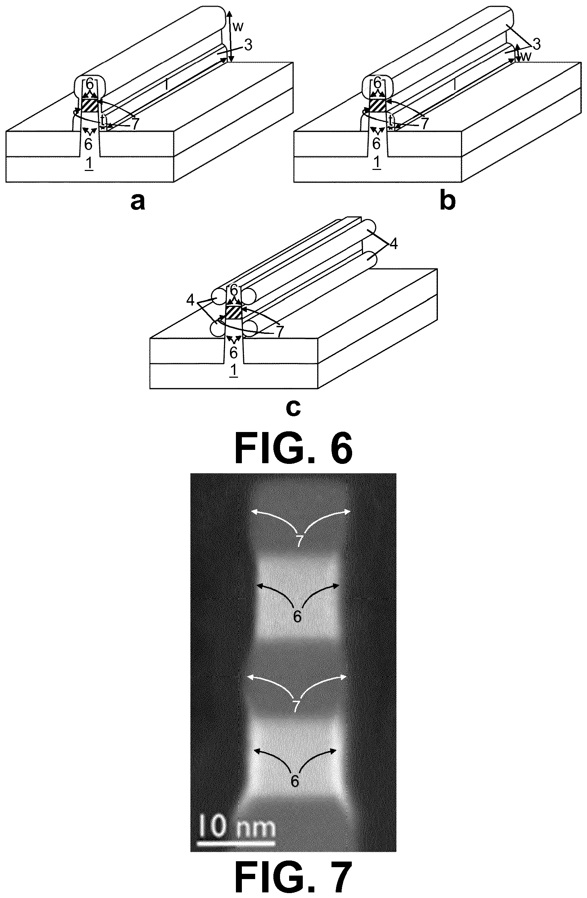

In some embodiments, when the elongated structure comprises a stack of layers, the step a2 (see infra) of epitaxially growing a strained layer of semiconductor material on the elongated structure may comprise growing the semiconductor material on both the monocrystalline surfaces of first material and the monocrystalline surfaces of second material (see Fig. 6a). In other embodiments, the step a2 (see infra) of epitaxially growing a strained layer of semiconductor material on the elongated structure may comprise growing the semiconductor material only on the monocrystalline surfaces of first material, but not the monocrystalline surfaces of second material (see Fig. 6b). The semiconductor material of the strained layer might for example not grow on the monocrystalline surfaces of second material when the difference between the intrinsic lattice constant of the semiconductor material forming the layer and the actual lattice constant of the second material is larger than 5%.

In embodiments, at least two of the two or more monocrystalline surfaces may be made of a first material having a first lattice constant difference with the semiconductor material and are separated from each other by at least one monocrystalline surface made of a second material having a second lattice constant difference with the semiconductor material; wherein the second material is chosen such that the second lattice constant difference is larger than the first lattice constant difference. The elongated structure may advantageously comprise monocrystalline surfaces of a first and second material, wherein contact to the second material constitutes a considerably larger potential energy for the semiconductor material as compared to contact to the first material. When this difference is large enough, it can advantageously be leveraged to move the semiconductor material away from the surfaces of second material upon reflow

Typically, the semiconductor material of the layer is a monocrystalline. In embodiments, the semiconductor material may be Si, Ge, SiGe or a III-V material. The III-V material may for example be InGaAs. A preferred material for the semiconductor material is Ge. It is particularly advantageous when grown on a monocrystalline surface made of SiGe.

In embodiments, the thickness (t) of the layer may be from 1 to 20 nm, preferably from 3 to 10 nm. A reflow of the semiconductor material may typically occur when the layer is sufficiently thin, such as 20 nm or smaller or 10 nm or smaller. It was found within the present invention that a layer having a large thickness (t), e.g. thickness (t) of 100 nm or more, will typically be sufficiently stable and will not undergo reflow.

In embodiments, the width (w) of the layer may be from 5 to 50 nm. In embodiments, the ratio between the width (w) and the thickness (t) of the layer may be larger than 1, preferably larger than 3. In embodiments, the length (1) of the layer of semiconductor material may be from 10 to 60 nm, preferably from 15 to 50 nm, yet more preferably from 15 to 40 nm.

The layer of semiconductor material is strained. This can for instance be achieved by growing the layer on a monocrystalline surface having actual lattice constants different from the corresponding intrinsic lattice constants of the semiconductor material making the layer.

In embodiments, the at least a surface of the elongated structure may have one or both actual lattice constants differing by at least 1%, and preferably by at least 1.5% with the intrinsic lattice constant of the semiconductor material of the layer grown thereon. This is advantageous as it typically permits the layer to be sufficiently strained to form a nanowire upon annealing.

In the case where the elongated structure has at least a surface having two different lattice constants, it is sufficient for one of these two lattice constants to be different in the manner indicated supra, e.g. by 1% or more, for the layer of semiconductor grown thereon to be sufficiently strained to reflow upon annealing.

In embodiments, the at least a surface of the elongated structure may have actual lattice constants differing by at most 6%, and preferably by at most 5% with the intrinsic lattice constant of the semiconductor material of the layer grown thereon. This is advantageous as it typically permits the layer to actually grow on that surface. A difference of more than 6% often prevent epitaxial growth.

Preferably, the layer of semiconductor material is compressively strained. This can for instance be achieved by growing the layer on a monocrystalline surface having at least one actual lattice constant which is smaller than the corresponding intrinsic lattice constant of the semiconductor material making the layer. This is preferably achieved by growing the layer on a monocrystalline surface having both its actual lattice constants smaller than the corresponding intrinsic lattice constants of the semiconductor material making the layer.

In the first aspect of the present invention, relaxing the strained layer comprises annealing the strained layer. Optionally, in addition to the annealing step, reducing the pressure of the environment (e.g. chamber) in which the layer is present also helps relaxing the strained layer.

In embodiments, annealing the layer may comprise annealing the layer at a temperature below its melting temperature but above 100 °C, preferably above 250 °C, yet more preferably above 300 °C, such as a temperature comprised in the range of from 300 to 600 °C. The temperature used is adapted to the semiconductor material. It is chosen so that it is above the reflow temperature of the material, i.e. sufficiently high for the reflow to occur, under the given environmental circumstances (e.g. pressure). In embodiments, annealing the layer may comprise heating the layer at a temperature not surpassing 100 °C below the melting temperature of the semiconductor material the layer is made of, preferably not surpassing 200 °C below that melting temperature, yet more preferably not surpassing 400 °C below that melting temperature. It is an advantage of the present invention that the formation of a nanowire via the reflow of the semiconductor material can be obtained at temperatures considerably below the melting temperature of the semiconductor material.

The annealing step may for example be provided during a subsequent processing step of the semiconductor device after providing the layer, such as for example during a subsequent gate stack formation.

In embodiments, changing the pressure of the environment in which the layer is present may comprise reducing the pressure in the environment to below 15 Torr, preferably to below 10 Torr. The substrate is typically provided under atmospheric pressure (760 Torr) and relaxing at least part of the layer can for instance be helped by reducing this pressure.

In embodiments, relaxing at least part of the layer by annealing the layer and optionally by additionally reducing the pressure of the environment in which the layer is present may be performed for 0.5 to 120 minutes, preferably for 1 to 60 minutes, yet more preferably for 2 to 20 minutes. It is an advantage of the present invention that the formation of a nanowire via the reflow of the semiconductor layer can be obtained within a few minutes of relaxing the layer.

In any embodiment of the present invention, the annealing step b may have for effect of bringing its width/thickness ratio of the strained layer closer to 1. This gradually transforms the layer into a nanowire. Typically, the length of the layer does not change by more than 20%, not even by more than 10%, not yet even by more than 5% and most typically does not change at all during the annealing.

In embodiments, the nanowire may have a diameter of 4 to 25 nm, preferably 4 to 12 nm, yet more preferably 5 to 8 nm.

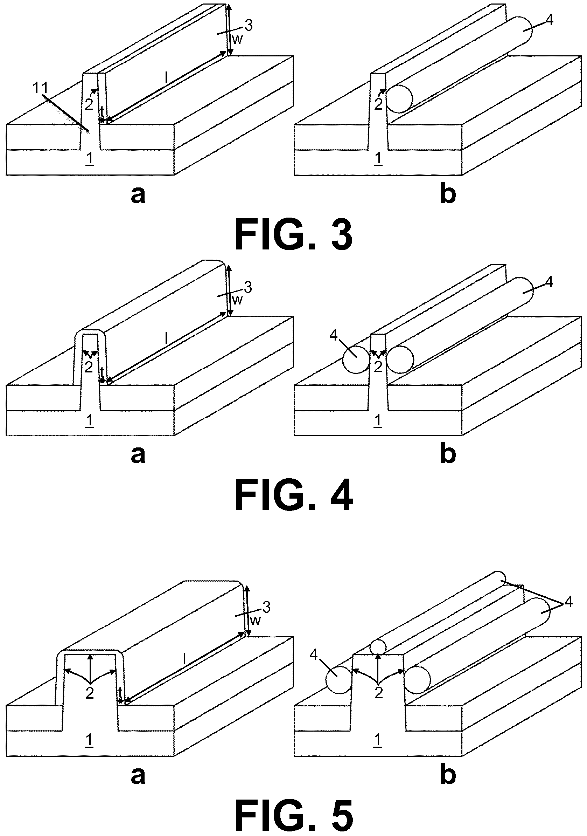

When a plurality of nanowires is obtained through the method according to embodiments of the first aspect, each nanowire may be located within 30 nm of another nanowire, preferably within 25 nm, yet more preferably within 20 nm, yet even more preferably within 10 nm and most preferably within 7 nm. As earlier described, embodiments of the present invention allow a plurality of nanowires, such a plurality of nanowires per elongated structure (e.g. Fig. 5b or Fig 5c), to be formed, wherein the nanowires are fixed in a position where they are spatially separated but still relatively close to one another.

In other embodiments, the doping may be performed uniformly along the length of the nanowire. In such embodiments, a n-type or p-type nanowire will be a nanowire which is

In embodiments, the nanowire may be formed on the surface on which the strained layer was or on an adjacent surface. Formation of the nanowire on an adjacent surface is favoured if the surface on which the strained layer was has a width of less than 30 nm. Formation of the nanowire on an adjacent surface is also favoured if the surface on which the strained layer was formed has actual lattice constants differing more from the intrinsic lattice constants of the material making up the strained layer than the actual lattice constants of the adjacent layer differs from these same intrinsic lattice constants.

In embodiments, after the formation of the semiconductor nanowire, the method may further comprise selectively etching at least a part of the surface of the elongated structure on which the nanowire is present, with respect to the semiconductor material, in order to expose a region of the at least one semiconductor nanowire that was in contact with the surface prior to the etching. Selectively etching at least part of the elongated structure, said part comprising the surface (e.g. etching the whole elongated structure) with respect to the semiconductor material advantageously allows the nanowire to be transversally detached from the surface, e.g. subsequently allowing a gate-all-around type gate to be formed. For example, when the semiconductor material is SiGe and the elongated structure material is Si, then a selective etching of the elongated structure can be achieved using an HCl based etching. Preferably, the nanowire is attached to the substrate via connection of its extremities to a structural element not comprising the elongated structure. This is advantageous because after selective removal of the elongated structure, the nanowire may advantageously remain suspended through the attachment at its extremities (the distance between said extremities corresponding to the length of the nanowire), e.g. the nanowire may remain suspended between source and drain contacts.

In embodiments, the method may comprise a step e, after step b if no step c2 or d2 is present or after step c2 or d2 if present (see infra), of removing the elongated structures selectively with respect to the semiconductor nanowires.

The method of the present invention can be used in the fabrication of a number of semiconductor device types. For instance, the nanowires obtained by the method may serve as interconnects in an integrated circuit. They may also be used as the channels from which a FET or a sensor can be fabricated. Sensors can make use of the nanowires obtained by the method of the invention according to the first aspect by measuring a change in conduction through the nanowire due to the influence of a chemical environment on the nanowire charge density. A particularly promising use of the method according to the first aspect is for fabricating a FET. A nanowire according to embodiments of the present invention can advantageously be used as a channel material in a FET. Fabricating this FET may advantageously comprise forming a gate over a portion of the length of the nanowire by covering the nanowire with one or more gate materials. In some embodiments, the gate may be a gate-all-around-type gate. In some embodiments, the transistor may be an inversion-mode FET having a source and a drain of a first doping type and either an undoped channel or a channel of a second doping type opposite to the first doping type. In other embodiments, the transistor may be a junctionless transistor wherein the whole nanowire is doped with dopants of a same type so that source, drain and channel have the same doping type.

In some embodiments, formation of a gate may involve a replacement metal gate process.

In an embodiment aimed at forming a FET (e.g. either inversion-mode or junctionless), the first aspect may further comprise the steps of:
- forming a gate stack comprising a gate dielectric and a gate electrode around a portion of the length of the nanowire comprised between the source and the drain regions.

In an embodiment aimed at forming an inversion-mode FET (also called MOSFET), the first aspect may further comprise the steps of:
- forming a source region at one extremity of the nanowire and a drain region at the other extremity of the nanowire,
- forming a gate stack comprising a gate dielectric and a gate electrode around a portion of the length of the nanowire.

In another embodiment aimed at forming a junctionless FET, the first aspect may further comprise the steps of:
- uniformly doping the source, drain and channel region of the nanowire with dopants of a same type,
- forming a gate layer comprising a gate dielectric and a gate electrode around a portion of the length of the nanowire comprised between the source and the drain regions.

In embodiments of the first aspect, a step of doping the nanowire may be performed. The nanowire are preferably doped after their formation but in some embodiments, it is possible to form doped strained layer, then to formed the doped nanowires by annealing these doped strained layers.

Doping the nanowire advantageously allows n- and/or p-type nanowires to be obtained.

In embodiments, the doping may be performed at the extremities of the nanowire to form a source and a drain region. In that case the channel present between the source and the drain region can be left undoped or can be doped with a polarity opposite to the polarity of the doping performed at the source and drain region. In such embodiments, a n-type or p-type nanowire will be a nanowire which source and drain are respectively entirely n-type or p-type doped. This is typically the case in the fabrication of a junctionless FET.

In embodiments of the first aspect, forming a source region and a drain region may comprise doping the nanowire at its extremities.

Doping may in some cases be achieved through injection of dopants through the extremities of the nanowire. In other cases, conformal doping may be performed. Doping may be achieved through a multitude of different techniques, such as ion implantation or conformal doping via doped glass deposition.

In embodiments, a plurality of nanowires may be produced and the doping may be such that the plurality of nanowires comprises at least one n-type nanowire and at least one p-type nanowire. Doping a plurality of nanowires to obtain both n- and p-type nanowires can advantageously allow a CMOS device to be created at the active device level (cf. infra).

A further step in the formation of a FET is the formation of electrical contacts on the source region, drain region and gate.

In embodiments, the plurality of nanowires may comprise at least one n-type nanowire and at least one p-type nanowire. The spatial separation of the nanowires in the plurality of nanowires may be used to obtain both an n- and p-type doped nanowires. For example, the nanowires may be stacked, i.e. they may be present at different heights above the substrate, and nanowires at a first height may be subject to a first doping with e.g. a doped glass deposition, while, before uncovering the nanowires at the first height, nanowires at a second height may be subject a second doping with e.g. an ion implanting; thus allowing a plurality of nanowires with both n- and p-type doping to be obtained.

In embodiments, the method of the first aspect may additionally comprise the steps of:
c1. Doping the semiconductor nanowires to form a semiconductor nanowires of a first doping type,
d1. after step c1, covering the semiconductor nanowires of a first doping type with a covering material while leaving at least another surface of each of the one or more elongated structures exposed,
a2. after step d1, providing a strained layer of semiconductor material on the at least another surface of each of the one or more elongated structures,
b2. annealing the one or more strained layers provided in step a2, thereby forming one or more semiconductor nanowires therefrom,
c2. After step b2, doping the one or more semiconductor nanowires to form one or more semiconductor nanowires of a second doping type opposite to the first doping type
d2. Removing the covering material.

In embodiments, in the method of the first aspect the strained layer(s) provided in step a is (are) of a semiconductor material of a first doping type and the anneal of step b forms nanowires of a first doping type therefrom the method further comprising the steps of:
c1. after step b, covering the semiconductor nanowires of a first doping type with a covering material while leaving at least another surface of each of the one or more elongated structures exposed,
a2. after step c1, providing a strained layer of semiconductor material of a second doping type opposite to the first doping type on the at least another surface of each of the one or more elongated structures,
b2. Annealing the one or more strained layers of a second doping type provided in step a2, thereby forming one or more semiconductor nanowires of a second doping type therefrom, and
c2. Removing the covering material.

In embodiments, in the method of the first aspect the strained layer(s) of a semiconductor material provided in step a is (are) of a first doping type and the method further comprises, before step b, the steps of:
a2. after step a, covering the strained layer of a semiconductor material of a first doping type with a covering material while leaving at least another surface of the one or more elongated structures exposed,
a3. after step a2, providing a strained layer of semiconductor material of a second doping type opposite to the first doping type on the at least another surface of the one or more elongated structures,
a4. removing the covering material.

A plurality of nanowires comprising both n- and p-type nanowires advantageously allows both n- and p-type FETs to be created and subsequently be connected into a CMOS device at the active device level, as opposed to the current limitation of needing to be connected at the middle- or back-end-of line level.

An intermediate structure, not forming part of the invention but considered useful for understanding the invention, resulting from the claimed method is disclosed in the fabrication of a semiconductor device comprising a semiconductor substrate having a plurality of parallel elongated structures thereon and a semiconductor nanowire on corresponding surfaces of each of these parallel elongated structures.

The semiconductor device, the semiconductor substrate, the plurality of parallel elongated structures and the semiconductor nanowire can be according to any embodiment of the first aspect.

A semiconductor device, not forming part of the invention but considered useful for understanding the invention, resulting from the claimed method is disclosed comprising a plurality of parallel nanowires wherein each nanowire is located within 30 nm, preferably within 10 nm, yet more preferably within 7 nm of another nanowire.

The semiconductor device and the plurality of parallel elongated structures can be according to any embodiment of the first aspect.

The semiconductor device may comprise at least one n-type nanowire and at least one p-type nanowire.

In preferred embodiments, the plurality of parallel nanowires may be organized in different parallel nanowire layers, stacked on each other, and wherein at least one nanowire layer is composed of n-type nanowires and at least one nanowire layer is composed of p-type nanowires.

A method for fabricating a semiconductor device, not forming part of the invention but considered useful for understanding the invention comprises:
a. Providing a stack of layers comprising a strained layer (3) of a first semiconductor material between two layers of a second semiconductor material,
b. removing part of the layers of the second semiconductor material at an extremity thereof, thereby reducing a contact area of the strained layer with the layers of the second semiconductor material, thereby freeing at least an extremity of the strained layer, said freed extremity extending from the stack, and
c. annealing the freed extremity.

The stack may comprise a plurality of strained layer of a first semiconductor material, each of these layers being between two layers of a second semiconductor material.

Like for the first aspect, it was surprisingly found that upon relaxing (i.e. upon reducing and preferably suppressing the strain) in an extremity of a layer of strained semiconductor material present on a substrate surface, the layer reflows (i.e. the semiconductor material rearranges spatially), while remaining in the solid state (i.e. without melting). In the present case, relaxing the extremity of the layer of strained semiconductor material was achieved by a combination of removing the original cause of the strain, i.e. the layer surface of the second material in contact with and underlying the extremity, and annealing. This effect could advantageously be used to form a nanowire-shaped structure from the extremity of the layer of semiconductor material by causing the freed extremity to reflow until a nanowire is formed.

The concept also based on the reflow of a semiconductor material creating lateral nanowires at pitch defined by the width of a template (the layers of the second semiconductor material). The width of the nanowire-shaped extremities is preferably such that charge carriers are confined therein by charge confinement effect. This can be achieved for instance with a width of less than 12nm and preferably less than 10nm for InGaAs, less than 8nm for Ge, and less than 4nm for Si. The main advantage of this aspect of the invention is that there is no need for detaching the nanowire-shaped features from the rest of the layer. The nanowire-shaped features produced by the fourth aspect can be used as interconnects or can be used as channel as indicated for any embodiment of the first aspect.

The strained layer of the first semiconductor material may be as indicated as suitable for forming the strained layer in any embodiment of the first aspect.

The second semiconductor material may be a material indicated as suitable for forming the elongated structure in any embodiment of the first aspect. The thickness of the layers of a second semiconductor material may be from 1 to 20 nm and preferably from 3 to 10 nm. A low thickness for the layer of a second semiconductor material is advantageous as it permits the nanowires formed from two successive layers of a first semiconductor material to be separated by no more than said thickness. This permits each nanowire-shaped feature formed in the fourth aspect to be located within 20 nm, preferably within 10 nm or even within 7 nm of another nanowire.

The extremity freed in step b may have a width to thickness ratio of from 3 to 1, preferably from 1.5 to 1.

Step c of annealing the freed extremity typically results in a rounded free extremity. Rounding the free extremity typically comprises, if the freed extremity has a width to thickness ratio above 1, bringing this ratio closer to 1. Rounding the free extremity also typically comprises, if the freed extremity has a cross-section taken perpendicularly to its length, said cross section having a perimeter, reducing the largest distance between the geometrical center of the cross-section and the point of the perimeter farther away from the center and increasing the smallest distance between the geometrical center of the cross-section and the point of the perimeter closest to the geometrical center.

In embodiments, the method may further comprise a step d of removing the rest of the layers of the second semiconductor material.

A semiconductor device, not forming part of the invention but considered useful for understanding the invention, is disclosed comprising a stack of layers comprising a layer of a first semiconductor material between layers of a second semiconductor material, wherein at least an extremity of the layer of a first semiconductor material extends from the stack and is rounded.

The first semiconductor material may be a layer of a material indicated as suitable for forming the strained layer in any embodiment of the first aspect and the second semiconductor material may be a material indicated as suitable for forming the elongated structures in any embodiment of the first aspect. Typically, the layer of first semiconductor material is strained where it contacts the layer of second semiconductor material but relaxed at its extremity extending from the stack.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Formation of strained layers on a strained fin

With reference to Fig. 1, a substrate (1) is provided, comprising a crystalline structure (1a), e.g. a Si wafer, and an optional isolation region such as a shallow trench isolation regions (1b) defined therein; the crystalline structure (1a) having a first lattice constant L₁ in all directions (both in directions parallel and perpendicular to the substrate top surface). If the crystalline structure is a Si wafer, L₁ is 5.42 Å. A fin (11) of a further material, e.g. Si_{0.75}Ge_{0.25}, is epitaxially grown on the top surface of the crystalline structure (1a), the further material adopting the first lattice constant L₁ parallel to the top surface of the crystalline structure (1a), but a second lattice constant L₂ perpendicular to the top surface of the crystalline structure (1a). If the further material is Si_{0.75}Ge_{0.25} which has an intrinsic lattice constant of 5.48 Å, this second lattice constant L₂ will take the value of 5.52 Å. This further material provides the monocrystalline surfaces (2a, 2b) on which the strained layer (3) of semiconductor material will be grown. It is noteworthy that this further material is itself strained and offers different lattice constants on its top surface (e.g. a single lattice constant of 5.42 Å) and its side surfaces (e.g. a first lattice constant equal 5.42 Å and a second lattice constant equal 5.52 Å). The semiconductor surface (2b) corresponding to the top surface of the fin (11) has the same (unique, since it is a square lattice) lattice constant as the top surface of the crystalline structure (1a) (e.g. both lattice constants equal 5.42 Å); while the semiconductor surface (2a) has two different lattice constants, one which is parallel to the top surface of the crystalline structure (1a) (e.g. 5.42 Å) and which is equal to the first lattice constant L₁, and one which is perpendicular to the top surface of the crystalline structure (1a) and which is equal to the second lattice constant L₂ (e.g. 5.52 Å). Now a layer (3) of a further material, e.g. Ge (intrinsic lattice constant equal 5.66 Å), is epitaxially grown strained on the fin, its actual lattice constants depending on which surface (2a or 2b) of the fin the material is grown on:
- the first lattice constant L₁ and the second lattice constant L₂ parallel to the semiconductor surface (2a) on which it is grown and L₃ perpendicularly to that semiconductor surface (2a),
- the first lattice constant L₁ for the two directions parallel to the semiconductor surface (2b) on which it is grown and the fourth lattice constant L₄ perpendicularly to that surface. It is to be noted that in the case of the Si/SiGe/Ge system exemplified here, since the differences (0.24 Å and 0.24 Å) between the intrinsic lattice constants of the further material (e.g. 5,66 Å for each of the two relevant constants) and the lattice constants of the top surface (2b) of the fin (e.g. 5.42 Å for each of the two constants) are larger than the differences (0.24 Å and 0.10 Å) between the intrinsic lattice constants of the further material (e.g. 5.66 Å for each of the two relevant constants) and the lattice constants of the sidewalls (5.42 Å and 5.52 Å), the layer of strained material will preferentially form nanowires on the sidewalls. The reason for this is that the layer of material will prefer to form on the surface where it is less strained, and the layer of material formed on the surface where it is more strained will tend to migrate, upon annealing, toward adjacent surfaces where it is less strained. This migration to adjacent surfaces depend also on the width of the more strained surface: the smaller this width, the more likely the migration to an adjacent surface. This phenomenon could be observed when the width of the fin was 15 nm as in the following example:

### Example 2: Formation of nanowires (4) against a fin with a width of 15 nm

We now refer to Fig. 2. A substrate (1) formed of a SiO₂ shallow trench isolation layer (STI) and of a Si base was provided. A Si_{0.75}Ge_{0.25} fin was epitaxially grown on top of the Si base and a thin Ge layer (3) was epitaxially grown on top of the fin. The epitaxial growth of Ge was performed at 350 °C using GeH₄ with a deposition time of about 2 min to obtain a 10 nm thick layer (Fig. 2a). Subsequently, the structure was annealed at 350 °C for several minutes, leading to a reflow of the Ge layer (3) to form two Ge nanowires (4), each on a side (2) of the fin (Fig. 2b).

### Example 3: Formation of a nanowire (4) against a sidewall of a fin

We now refer to Fig. 3 (a). A substrate (1) on which a fin (11) is epitaxially grown has a strained layer (3) of semiconductor material on a side surface (2) of the fin (11). The layer is depicted with its thickness (t), width (w) and length (1). We now refer to Fig. 3 (b); After annealing, a nanowire (4) is formed on the side surface (2). Example 3 does not fall within the scope of the claimed invention.

### Example 4: Formation of a nanowires (4) from strained layers present on each wall of a fin

We now refer to Fig. 4 and Fig. 5. In Fig. 4a, layers of strained semiconductor material are provided on the top surface (2) and both side surfaces (2) of a thin fin having a width of less than 30 nm. In Fig. 5a, layers of strained semiconductor material are provided on the top surface (2) and both side surfaces (2) of a fin having a width of more than 30 nm. After annealing, a nanowire (4) is formed on the side surfaces (2) only in the case Fig. 4b and on both side surfaces (2) and the top surface (2) in.the case of Fig. 5b.

### Example 5: Formation of a fin comprising surfaces (2) of different materials

We now refer to Fig. 7. Alternating layers of a first material (SiGe) (6) and a second material Si (7) were epitaxially grown on a Si substrate (1), which was prepared using ion implantation; using SiH₄ and GeH₄ as precursors and an N₂/H₂ carrier gas below 20 Torr for the epitaxial growth. The obtained SiGe layers (6) contained about 30% Ge, using growth temperatures above 600 °C. SiGe/Si fins were subsequently patterned in the SiGe/Si layers by sidewall image transfer, and the STI trenches were filled with an oxide.

### Example 6: Formation of nanowires stacked vertically

We now refer to Fig. 6. A film of semiconductor material (3), such as Ge, is grown over fins formed of a stack of layers comprising two layers made of a first material (6) separated by a layer made of a second material (7). This is depicted in Figs. 6a and 6b. The stack can for instance be as obtained in Example 5. In Fig. 6a, the layer of semiconductor material (3) (e.g. Ge) grew on both the first material (6) and the second material (7) but grew thicker on the first material. This can occur for instance when the second material (7) (e. Si_{0.70}Ge_{0.30}) has lattice constants not too different from the lattice constant of the first material (6) (e.g. Si), e.g. for a low Ge content such as the 30% obtained in example 5. To obtain SiGe layers (6) containing a higher proportion of Ge, a lower temperature is preferably used to avoid intermixing and Si₂H₆ (or Si₃H₈) and Ge₂H₆ are preferably used as precursors. Fig. 6b shows the situation where the layer of semiconductor material (3) grew only on the first material. This can for instance occur when the second material (7) has lattice constants far apart from the lattice constants of the first material (6). We now turn to Fig. 6c. After annealing, nanowires (4) are formed only on the surfaces made of the first material (6), this independently of the presence or absence of the semiconductor material layer (3) on the second material (7).

### Example 7: Forming nanowires of a first and a second polarity with a pitch twice larger for the nanowires of a first or second polarity.

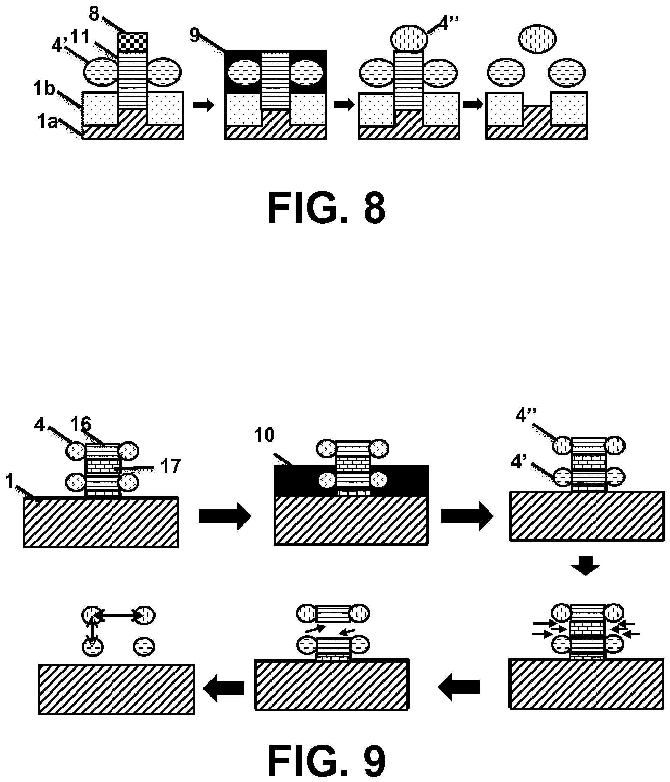

We now refer to the Fig. 8. A substrate (1) formed of a SiO₂ shallow trench isolation layer (STI, 1b) and of a Si base (1a) is provided. A SiN hard mask (8) is provided on top of the fin (11) to mask its top surface. After annealing, nanowires (4) are formed. A Si_{0.50}Ge_{0.50} fin (11) is epitaxially grown on top of the Si base (1a) and a thin Ge layer (not shown) is epitaxially grown on top of the fin. Subsequently, the structure is annealed at a temperature and for a time sufficient to reflow the Ge layer (3) to form two Ge nanowires (4), each on a side of the fin (11). Next, the nanowires (4) are doped by conformal doping or ion implantation. Next, an interlayer (9) is deposited and planarized by CMP to expose the top surface of the fin (11). After a cleaning step, a silicon layer is deposited on the top surface of the fin (11) then this Si layer is annealed and a Si nanowire (4') is formed. Next, this nanowire (4') is doped with a polarity opposite to the polarity of the Ge nanowires. Next, the interlayer is removed. Next, the p-type and the n-types nanowires are released by removing the fin.

### Example 8: Formation of parallel nanowire layers of alternating doping type

We now refer to Fig. 9. We start with a structure analogous to Fig. 6c of example 6 which is represented at the top left of Fig. 9. Next, the nanowire (4) layer closest to the substrate is doped by conformal doping with dopants of a first type, thereby forming a doped nanowire (4') layer of a first type. This is performed via the use of a doped glass layer (10) covering that nanowire (4) layer. Next, the nanowire layer farthest from the substrate is doped by ion implantation, thereby forming a doped nanowire (4") layer of a second type. The resulting structure is the second structure at the top of Fig. 9. Next, the glass layer (10) is removed. This is depicted on the top right of Fig. 9. Next, the fin (16, 17) is removed, freeing the sidewalls of the doped nanowires (4', 4"). The nanowires (4', 4") can be indirectly anchored to the substrate (1) via e.g. attachment to source and drain contacts (not shown).

### Example 9: Relaxing free extremities extending form a stack of layers

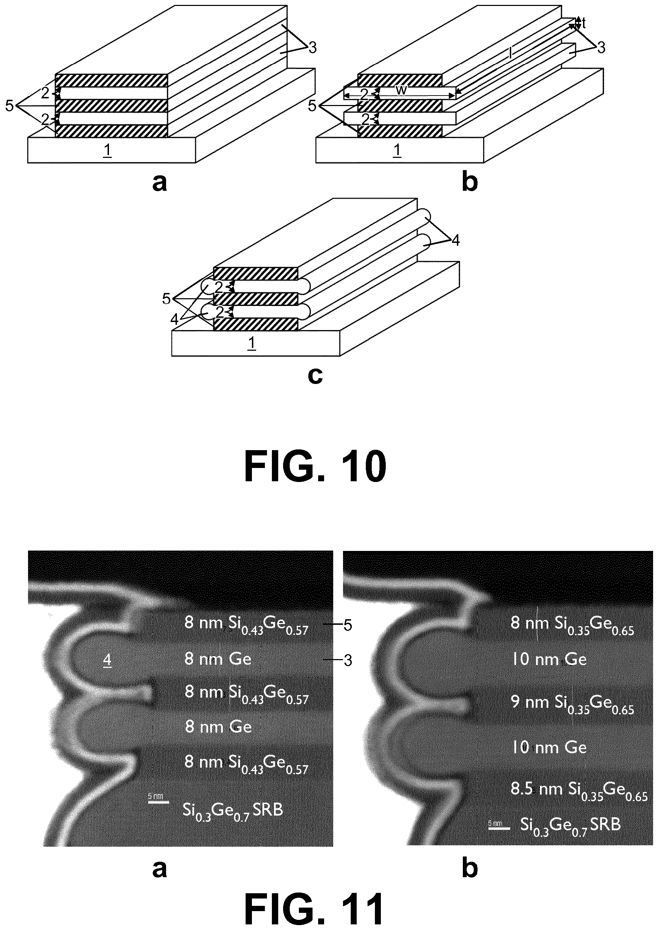

We now refer to Fig. 10. In this embodiment, not falling within the scope of the claimed invention, the layer of semiconductor material is a layer (3) comprised in a stack of layers. The stack of layers may comprise layers (3) of semiconductor material alternated with layers of a further material (5) having at least one monocrystalline surface (2). The layer (3) is in contact with a monocrystalline surface (2) at its bottom, its top, or both (see Fig. 10a). Relaxing part of the layer in such a case may comprise removing part of the layers (5), thereby reducing a contact area of the layer with the monocrystalline surfaces (2), thereby forming at least one free extremity, i.e. an end portion of the layer which is not in contact with the further material (5), extending from the stack (Fig. 10b). Removing part of the layers (5) combined with annealing typically results in a reflow of the semiconductor material in the freed extremity, leading to the formation of a nanowire-shaped feature (4) attached to the remainder of the layer in the stack (Fig. 10c). In embodiments, the stack of layers wherein the layer has a free extremity extending therefrom may be obtained from a stack of layers, having no such extending free extremity (Fig. 10a) and subsequently selectively recessing the further material (5) with respect to the layer (Fig. 10b). Wherein selectively recessing the further material (5) consists of at least partially removing the further material (5), from a side of the stack inwards, thereby reducing the contact area of the layer with at least one monocrystalline surface (2). In embodiments, relaxing the layer may comprise reducing the contact area of the layer with the at least one second layer (2) by means of the selective recessing, combined with annealing.

We now refer to Fig. 11. A stack of Si_{0.43}Ge_{0.57} (Fig. 11a) or Si_{0.35}Ge_{0.65} (Fig. 11b) layers (5), alternated with Ge layers (3), was grown on a Si_{0.3}Ge_{0.7} strain relaxed buffer (SRB). The SiGe (5) was partially recessed, selectively with respect to the Ge layers (3), thereby yielding Ge layers (3) having free extremities extending from the stack. As earlier explained (e.g. see Fig. 10), this selective recessing in turn triggered upon annealing a relaxation of the free extremities, forming nanowires (4) attached to the remainder of the Ge layers (3).

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

The scope of the present invention is defined exclusively by the appended claims.

## Claims

1. A method for fabricating a semiconductor device, comprising the steps of:
a. providing a semiconductor substrate (1) having one or more elongated structures (11) thereon and providing a strained layer (3) of semiconductor material on two or more surfaces (2) of each of the one or more elongated structures, and
b. annealing the one or more strained layers (3),
**characterized in that**, by means of step b, two or more semiconductor nanowires (4) are formed on each of the one or more elongated structures from the one or more strained layers (3) present on the two or more surfaces (2).

2. The method according to claim 1, wherein the one or more elongated structures (11) are a plurality of parallel elongated structures (11).

3. The method according to claim 1 or claim 2, wherein step a comprises providing a semiconductor substrate (1) having one or more elongated structures (11) thereon, each of the one or more elongated structures having two sidewalls (2) opposite each other, and wherein a strained layer (3) of semiconductor material is on each of said two sidewalls (2) of each of the one or more elongated structures.

4. The method according to claim 3, wherein step a comprises providing a semiconductor substrate (1) having one or more elongated structures (11) thereon, each of the one or more elongated structures (11) having a top surface (2), and wherein a strained layer (3) of semiconductor material is on each top surface (2) of each of the one or more elongated structures.

5. The method according to any one of the preceding claims, further comprising the steps of:
c1. doping the semiconductor nanowires (4) to form semiconductor nanowires (4') of a first doping type,
d1. after step c1, covering the semiconductor nanowires (4') of a first doping type with a covering material (9) while leaving at least another surface (2) of each of the one or more elongated structures (11) exposed,
a2. after step d1, providing a strained layer (3) of semiconductor material on the at least another surface (2) of each of the one or more elongated structures (11),
b2. annealing the one or more strained layers (3) provided in step a2, thereby forming one or more semiconductor nanowires (4) therefrom,
c2. after step b2, doping the one or more semiconductor nanowires (4) formed in step b2 to form one or more semiconductor nanowires (4") of a second doping type opposite to the first doping type
d2. removing the covering material (9).

6. The method according to any one of the preceding claims, wherein each elongated structure (11) provided in step a is formed of a stack of layers (16, 17) comprising two layers (16) made of a first material separated by a layer (17) made of a second material, thereby providing one or more elongated structures (11) having sidewalls which each comprises two surfaces (6) made of the first material separated by a surface (7) made of the second material, wherein a strained layer (3) of semiconductor material is on each surface (6) made of the first material.

7. The method according to claim 6, wherein the surface (6) made of the first material has a first lattice constant and wherein the surface (7) made of the second material has a second lattice constant smaller than the first lattice constant.

8. The method according to any one of the preceding claims, further comprising a step e, after step b if no step d2 is present or after step d2 if present, of removing each of the one or more elongated structures (11) selectively with respect to the semiconductor nanowires (4).

9. The method according to any one of the preceding claims, wherein the one or more strained layers (3) are compressively strained.

10. The method according to any of claims 1 to 4, wherein a plurality of strained layers (3) are provided in step a and wherein a plurality of nanowires (4) are produced in step b, the method further comprising a step of doping the plurality of strained layers (3) or the plurality of nanowires (4) in such a way that the at least one n-type nanowire (4', 4") and at least one p-type nanowire (4", 4') are provided.

11. The method according to any one of the preceding claims, wherein a plurality of strained layers (3) are provided in step a and wherein a plurality of nanowires (4) per elongated structure are produced in step b, wherein each nanowire (4) of an elongated structure is located within 30 nm, preferably within 10 nm, yet more preferably within 7 nm of another nanowire (4) of the same elongated structure.

## Patentansprüche

1. Ein Verfahren zum Herstellen einer Halbleitervorrichtung, das die Schritte umfasst zum:
a.- Bereitstellen eines Halbleitersubstrats (1), das eine oder mehrere längliche Strukturen (11) darauf aufweist, und Bereitstellen einer gespannten Schicht (3) aus Halbleitermaterial auf zwei oder mehr Oberflächen (2) einer jeden der einen oder mehreren länglichen Strukturen, und
b.- Anlassen der einen oder mehreren gespannten Schichten (3), **dadurch gekennzeichnet, dass**, anhand von Schritt b zwei oder mehr Halbleiter-Nanodrähte (4) auf jeder der einen oder mehreren länglichen Strukturen aus der einen oder mehreren gespannten Schichten (3) gebildet werden, die auf den zwei oder mehr Oberflächen (2) vorhanden sind.

2. Das Verfahren nach Anspruch 1, wobei die eine oder mehrere längliche Strukturen (11) eine Vielzahl von parallelen länglichen Strukturen (11) sind.

3. Das Verfahren nach Anspruch 1 oder Anspruch 2, wobei Schritt a Bereitstellen eines Halbleitersubstrats (1) umfasst, das eine oder mehrere längliche Strukturen (11) darauf aufweist, wobei jede der einen oder mehreren länglichen Strukturen zwei Seitenwände (2) einander gegenüber aufweist, und wobei eine gespannte Schicht (3) aus Halbleitermaterial auf jeder der beiden Seitenwände (2) jeder der einen oder mehreren länglichen Strukturen vorhanden ist.

4. Das Verfahren nach Anspruch 3, wobei Schritt a Bereitstellen eines Halbleitersubstrats (1) umfasst, das eine oder mehrere längliche Strukturen (11) darauf aufweist, wobei jede der einen oder mehreren länglichen Strukturen (11) einen obere Oberfläche (2) aufweist, und wobei eine gespannte Schicht (3) aus Halbleitermaterial auf jeder oberen Oberfläche (2) jeder der einen oder mehreren länglichen Strukturen vorhanden ist.

5. Das Verfahren nach einem der vorstehenden Ansprüche, weiter umfassend die Schritte zum:
c1.- Dotieren der Halbleiter-Nanodrähte (4), um Halbleiter-Nanodrähte (4') eines ersten Dotierungstyps zu bilden,
d1.- Abdecken nach Schritt c1 der Halbleiter-Nanodrähte (4') eines ersten Dotierungstyps mit einem Abdeckmaterial (9) während mindestens eine andere Oberfläche (2) jeder der einen oder mehreren länglichen Strukturen (11) freigelegt bleibt,
a2.- Bereitstellen nach Schritt d1 einer gespannten Schicht (3) aus Halbleitermaterial auf der mindestens einen anderen Oberfläche (2) jeder der einen oder mehreren länglichen Strukturen (11),
b2.- Anlassen der einen oder mehreren in Schritt a2 bereitgestellten gespannten Schichten (3), wodurch ein oder mehrere Halbleiter-Nanodrähte (4) daraus gebildet werden,
c2.- Dotieren nach Schritt b2 des einen oder mehrerer in Schritt b2 gebildeter Halbleiter-Nanodrähte (4), um einen oder mehrere Halbleiter-Nanodrähte (4") eines zweiten Dotierungstyps entgegengesetzt zum ersten Dotierungstyp zu bilden,
d2.- Entfernen des Abdeckmaterials (9).

6. Das Verfahren nach einem der vorstehenden Ansprüche, wobei jede in Schritt a bereitgestellte längliche Struktur (11) aus einem Stapel von Schichten (16, 17) bereitgestellt ist, die zwei Schichten (16) umfasst, die aus einem ersten Material hergestellt ist, durch eine Schicht (17) getrennt, die aus einem zweiten Material hergestellt ist, wodurch eine oder mehrere längliche Strukturen (11) bereitgestellt werden, die Seitenwände aufweisen, die jeweils zwei Oberflächen (6) umfassen, die aus einem ersten Material hergestellt sind, durch eine Oberfläche (7) getrennt, die aus einem zweiten Material hergestellt sind, wobei eine gespannte Schicht (3) aus Halbleitermaterial auf jeder Oberfläche (6), die aus dem ersten Material hergestellt ist, vorhanden ist.

7. Das Verfahren nach Anspruch 6, wobei die Oberfläche (6), die aus dem ersten Material hergestellt ist, eine erste Gitterkonstante aufweist, und wobei die Oberfläche (7), die aus dem zweiten Material hergestellt ist, eine zweite Gitterkonstante aufweist, die kleiner als die erste Gitterkonstante ist.

8. Das Verfahren nach einem der vorstehenden Ansprüche, die weiter einen Schritt e nach Schritt b, falls kein Schritt d2 vorhanden ist, oder nach Schritt d2, falls vorhanden, zum selektiven Entfernen jeder der einen oder mehreren Strukturen (11) in Bezug auf die Halbleiter-Nanodrähte (4) umfasst.

9. Das Verfahren nach einem der vorstehenden Ansprüche, wobei die eine oder mehrere Schichten (3) durch Kompression gespannt sind.

10. Das Verfahren nach einem der Ansprüche 1 bis 4, wobei eine Vielzahl von gespannten Schichten (3) in Schritt a bereitgestellt sind und eine Vielzahl von Nanodrähten (4) in Schritt b hergestellt wird, wobei das Verfahren weiter einen Schritt zum Dotieren der Vielzahl von gespannten Schichten (3) oder der Vielzahl von Nanodrähten (4) derart umfasst, dass der mindestens eine Nanodraht vom n-Typ (4', 4") und mindestens eine Nanodraht vom p-Typ (4", 4') bereitgestellt werden.

11. Das Verfahren nach einem der vorstehenden Ansprüche, wobei eine Vielzahl von gespannten Schichten (3) in Schritt a bereitgestellt wird und wobei eine Vielzahl von Nanodrähten (4) je länglicher Struktur in Schritt b hergestellt wird, wobei sich jeder Nanodraht (4) einer länglichen Struktur innerhalb von 30 nm, vorzugsweise innerhalb von 10 nm, bevorzugter innerhalb von 7 nm zu einem anderen Nanodraht (4) der gleichen länglichen Struktur befindet.

## Revendications

1. Un procédé de fabrication d'un dispositif semi-conducteur, comprenant les étapes de :
a. fournir un substrat semi-conducteur (1) ayant une ou plusieurs structures allongées (11) dessus et fournir une couche contrainte (3) de matériau semi-conducteur sur deux ou plusieurs surfaces (2) de chacune desdites une ou plusieurs structures allongées, et
b. recuire ladite ou lesdites couches contraintes (3),
**caractérisé en ce que**, par le biais de l'étape b, deux ou plusieurs nanofils semi-conducteurs (4) sont formés sur chacune desdites une ou plusieurs structures allongées à partir de ladite ou desdites couches contraintes (3) présentes sur lesdites deux ou plusieurs surfaces (2).

2. Le procédé selon la revendication 1, dans lequel ladite ou lesdites structures allongées (11) sont une pluralité de structures allongées parallèles (11).

3. Le procédé selon la revendication 1 ou la revendication 2, dans lequel l'étape a comprend la fourniture d'un substrat semi-conducteur (1) ayant une ou plusieurs structures allongées (11) dessus, chacune desdites une ou plusieurs structures allongées ayant deux parois latérales (2) opposées l'une à l'autre, et dans lequel une couche contrainte (3) de matériau semi-conducteur est sur chacune desdites deux parois latérales (2) de chacune desdites une ou plusieurs structures allongées.

4. Le procédé selon la revendication 3, dans lequel l'étape a comprend la fourniture d'un substrat semi-conducteur (1) ayant une ou plusieurs structures allongées (11) dessus, chacune desdites une ou plusieurs structures allongées (11) ayant une surface supérieure (2), et dans lequel une couche contrainte (3) de matériau semi-conducteur est sur chaque surface supérieure (2) de chacune desdites une ou plusieurs structures allongées.

5. Le procédé selon l'une quelconque des revendications précédentes, comprenant en outre les étapes de :
c1. dopage desdits nanofils semi-conducteurs (4) pour former des nanofils semi-conducteurs (4') d'un premier type de dopage,
d1. après l'étape c1, recouvrir lesdits nanofils semi-conducteurs (4') d'un premier type de dopage avec un matériau de couverture (9) tout en laissant au moins une autre surface (2) de chacune desdites une ou plusieurs structures allongées (11) exposée,
a2. après l'étape d1, fournir une couche contrainte (3) de matériau semi-conducteur sur ladite au moins une autre surface (2) de chacune desdites une ou plusieurs structures allongées (11),
b2. recuire ladite ou lesdites couches contraintes (3) fournies à l'étape a2, formant ainsi un ou plusieurs nanofils semi-conducteurs (4) à partir de celles-ci,
c2. après l'étape b2, dopage dudit ou desdits nanofils semi-conducteurs (4) formés à l'étape b2 pour former un ou plusieurs nanofils semi-conducteurs (4") d'un second type de dopage opposé au premier type de dopage,
d2. retirer ledit matériau de couverture (9).

6. Le procédé selon l'une quelconque des revendications précédentes, dans lequel chaque structure allongée (11) fournie à l'étape a est formée d'un empilement de couches (16, 17) comprenant deux couches (16) faites d'un premier matériau séparées par une couche (17) faite d'un second matériau, fournissant ainsi une ou plusieurs structures allongées (11) ayant des parois latérales qui comprennent chacune deux surfaces (6) faites du premier matériau séparées par une surface (7) faite du second matériau, dans lequel une couche contrainte (3) de matériau semi-conducteur est sur chaque surface (6) faite du premier matériau.

7. Le procédé selon la revendication 6, dans lequel ladite surface (6) faite du premier matériau a une première constante de réseau et dans lequel ladite surface (7) faite du second matériau a une seconde constante de réseau inférieure à la première constante de réseau.

8. Le procédé selon l'une quelconque des revendications précédentes, comprenant en outre une étape e, après l'étape b si aucune étape d2 n'est présente ou après l'étape d2 si elle est présente, de retirer chacune desdites une ou plusieurs structures allongées (11) sélectivement par rapport auxdits nanofils semi-conducteurs (4).

9. Le procédé selon l'une quelconque des revendications précédentes, dans lequel ladite ou lesdites couches contraintes (3) sont sous contrainte de compression.

10. Le procédé selon l'une quelconque des revendications 1 à 4, dans lequel une pluralité de couches contraintes (3) sont fournies à l'étape a et dans lequel une pluralité de nanofils (4) sont produits à l'étape b, le procédé comprenant en outre une étape de dopage de ladite pluralité de couches contraintes (3) ou de ladite pluralité de nanofils (4) de manière à ce qu'au moins un nanofil de type n (4', 4") et au moins un nanofil de type p (4", 4') soient fournis.

11. Le procédé selon l'une quelconque des revendications précédentes, dans lequel une pluralité de couches contraintes (3) sont fournies à l'étape a et dans lequel une pluralité de nanofils (4) par structure allongée sont produits à l'étape b, dans lequel chaque nanofil (4) d'une structure allongée est situé à moins de 30 nm, de préférence à moins de 10 nm, encore plus préférablement à moins de 7 nm d'un autre nanofil (4) de la même structure allongée.
